# EUROPEAN PATENT SPECIFICATION

(11) **EP 3 666 781 B1**
(45) Date of publication and mention of the grant of the patent: **27.11.2024**
(21) Application number: 18843962.4
(22) Date of filing: 22.06.2018
(51) Int. Cl.: C07F 7/18, C08K 5/5415, C08K 5/5425, C08L 83/05, C08L 83/07

(54) **ORGANOSILICON COMPOUND AND THERMOSETTING HEAT CONDUCTIVE SILICONE COMPOSITION**
ORGANOSILIZIUMVERBINDUNG UND WÄRMEHÄRTENDE WÄRMELEITFÄHIGE SILIKONZUSAMMENSETZUNG
COMPOSÉ D'ORGANOSILICIUM ET COMPOSITION DE SILICONE THERMOCONDUCTRICE THERMODURCISSABLE

(30) Priority: 10.08.2017 JP 2017156157
(43) Date of publication of application: 17.06.2020
(73) Proprietor: Shin-Etsu Chemical Co., Ltd., Tokyo 100-0005 (JP)
(72) Inventor: ISHIHARA, Yasuhisa, Annaka-shi Gunma 379-0224 (JP); FUKAMACHI, Takumi, Annaka-shi Gunma 379-0224 (JP); OZAI, Toshiyuki, Annaka-shi Gunma 379-0224 (JP); ENDO, Akihiro, Annaka-shi Gunma 379-0224 (JP)
(74) Representative: Wibbelmann, Jobst
(86) International application number: PCT/JP2018/023903
(87) International publication number: WO 2019/031082

(56) References cited:
- WO-A1-2017/012714
- JP-A- 2005 325 212
- JP-A- 2007 332 104
- JP-A- 2008 019 426
- JP-A- 2008 056 761
- JP-A- 2011 178 821
- JP-A- 2012 007 057
- JP-A- 2014 062 198
- JP-A- 2017 222 819
- US-A1- 2008 057 325

## Description

### TECHNICAL FIELD

The present invention relates to a novel organic silicon compound and a curable thermal conductive silicone composition.

### BACKGROUND ART

A semiconductor such as a transistor or a diode used in an electronic device such as a converter or a power source is, accompanying an advance of high performance, high speed, miniaturization and high integration, generating a larger amount of heat by itself, and a temperature increase of a device due to the heat causes malfunction and breakdown. Therefore, in order to suppress a temperature increase of the semiconductor during operation, many heat dissipation methods and heat dissipation members used for the methods have been proposed. As a general heat dissipation member, various shapes such as a composition in which a heat conductive filler is filled in a polymer matrix, a cured material obtained by curing the same, or a composite sheet obtained by laminating the cured material and a reinforcement material may be used. The heat dissipation member is mounted between a heat generation member and a heat dissipation member, and its shape is selected depending on a mounting state.

As the polymer matrix of the heat dissipation member, silicone, acryl, and olefin may be used. However, from the viewpoints of heat resistance, cold resistance, and long term reliability, the silicone is most suitable.

As the polymer matrix of the heat dissipation member in semiconductor elements having particularly large heat generation amount or in a vehicle mounting field demanded to have long term reliability, from the viewpoints of heat resistance, cold resistance, and long term reliability, the silicone is frequently used.

Recently, a heat generation amount of heat generation components such as semiconductors increases more and more, and the thermal conductivity demanded for the heat dissipation member increases. Furthermore, in particular, in the field of vehicle mounting field, a vibration is added to the heat generation component, that is, an environment to which the heat dissipation member is exposed is severe.

In order to impart the thermal conductivity to the heat dissipation member, a heat conductive filler may be filled in a silicone matrix. As shown in Patent Literatures 1 to 4, in order to fill a heat conductive filler at a high density in the silicone matrix, it is known to use polysiloxane or a silane coupling agent having a hydrolysable group. When one obtained by curing a curable thermal conductive silicone composition is used as the silicone matrix, a filling amount of the heat conductive filler increases, a ratio occupied by the silicone matrix relatively decreases, the strength of the cured material is damaged. Furthermore, when a ratio occupied by the hydrolyzable polysiloxane in the silicone is increased, the heat conductive filler may be filled more, however, since a ratio occupied by the silicone component regarding the curing decreases, the strength of the cured material is further damaged. Curable thermal conductive silicone compositions are disclosed in Patent Literature 5.

### CITATION LIST

### PATENT LITERATURE

Patent Literature 1: Japanese Patent Application No. H11-64173
Patent Literature 2: Japanese Patent No. 3290127
Patent Literature 3: Japanese Patent Laid-Open Publication 2004-262972
Patent Literature 4: Japanese Patent Laid-Open Publication 2005-162975 Patent Literature 5: US 2008/057325 A1

### SUMMARY OF INVENTION

### TECHNICAL PROBLEM

Now, in view of the above situation, the present invention intends to provide an organic silicon compound used in a curable thermal conductive silicone composition capable of filling a heat conductive filler at a high density, and further capable of suppressing a decrease in the strength even when the heat conductive filler is filled at a high density.

### SOLUTION TO PROBLEM

In order to solve the above problem, the present invention provides a curable thermal conductive silicone composition characterized by including:
(A) organopolysiloxane having at least two alkenyl groups bonded to a silicon atom in a molecule; 100 parts by mass,
(B) organohydrogenpolysiloxane having at least two hydrogen atoms directly bonded to a silicon atom in a molecule; the number of moles of hydrogen atoms directly bonded to a silicon atom is an amount to be 0.1 to 5.0 times the number of moles of alkenyl groups derived from the (A) component,
(C) a heat conductive filler; 200 to 3000 parts by mass,
(D) a platinum-based curing catalyst; an amount to be 0.1 to 1000 ppm in terms of the platinum group element mass relative to the (A) component,
(E) an addition reaction control agent; an effective amount, and(F-1) an organic silicon compound represented by the following general formula (1);1 to 200 parts by mass: 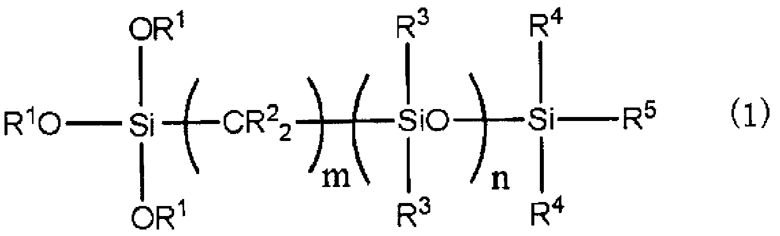 in the formula (1), R1 respresents an alkyl group having 1 to 6 carbon atoms, R2 represents independently a hydrogen atom, a nonsubstituted monovalent hydrocarbon group, or a group obtained by substituting a part or all of hydrogen atoms bonded to carbon atoms of a monovalent hydrocarbon group with halogen atoms, R3 and R4 each represents independently a nonsubstituted monovalent hydrocarbon group, or a group obtained by substituting a part or all of hydrogen atoms bonded to carbon atoms of a monovalent hydrocarbon group with halogen atoms, and R5 represents a hydrogen atom or an alkenyl group, and m represents an integer of 1 to 30, and n represents an integer of 3 to 4.

The organic silicon compound like this becomes an organic silicon compound capable of suitably using in a curable thermal conductive silicone composition capable of suppressing a decrease of the strength of a cured material even when the heat conductive filler is filled at the high density.

The curable thermal conductive silicone composition like this becomes a curable thermal conductive silicone composition capable of filling the heat-conductive filler at a high density and further capable of suppressing a decrease in the strength even when the heat-conductive filler is filled at the high density.

Furthermore, the composition of the present invention is preferably a curable thermal conductive silicone composition including
(A) organopolysiloxane having at least two alkenyl groups bonded to a silicon atom in a molecule; 100 parts by mass,
(B) organohydrogenpolysiloxane having at least two hydrogen atoms directly bonded to a silicon atom in a molecule; the number of moles of hydrogen atoms directly bonded to a silicon atom is an amount to be 0.1 to 5.0 times the number of moles of the alkenyl groups derived from the (A) component,
(C) a heat conductive filler; 200 to 3000 parts by mass,
(D) a platinum-based curing catalyst; the amount to be 0.1 to 1000 ppm in terms of the platinum group element mass relative to the (A) component,
(E) an addition reaction control agent; an effective amount, and
(F-1) an organic silicon compound represented by the above general formula (1); 0.01 to 200 parts by mass.

The curable thermal conductive silicone composition like this becomes a curable thermal conductive silicone composition capable of filling the heat-conductive filler at a higher density, furthermore capable of suppressing a decrease in the strength even when the heat-conductive filler is filled at a high density.

Furthermore, a curable thermal conductive silicone composition is preferable to contain 0.01 to 110 parts by mass of at least one kind selected from the group consisting of, as a (F-2) component, an alkoxysilane compound represented by the following general formula (2)

**R⁶ₐR⁷_{b}Si(OR⁸)_{4-a-b}** **(2)**

wherein in the formula (2), R6 represents independently an alkyl group having 6 to 15 carbon atoms, R7 represents independently a nonsubstituted monovalent hydrocarbon group having 1 to 12 carbon atoms, or a group obtained by substituting a part or all of hydrogen atoms bonded to a carbon atom in a monovalent hydrocarbon group having 1 to 12 carbon atoms with a halogen atom or a cyano group, R8 represents independently an alkyl group having 1 to 6 carbon atoms, and "a" represents an integer of 1 to 3, and "b" represents an integer of 0 to 2, however, a + b is an integer of 1 to 3,and, as a (F-3) component, dimethylpolysiloxane represented by the following general formula (3) in which one terminal of the molecular chain is sealed with a tri-alkoxy group: 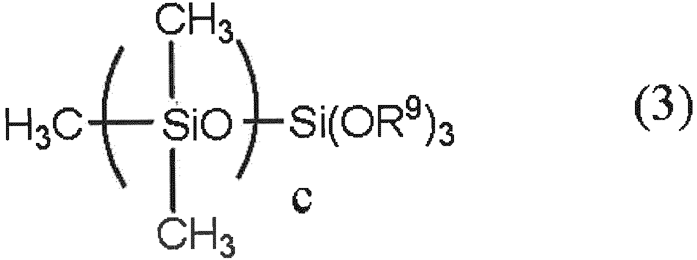 in the formula (3), R9 represents independently an alkyl group having 1 to 6 carbon atoms and c is an integer of 5 to 100.

The curable thermal conductive silicon composition containing the (F-2) component and (F-3) component like this becomes a curable thermal conductive silicone composition capable of more dispersing a heat-conductive filler.

### ADVANTAGEOUS EFFECTS OF THE INVENTION

As described above, since the organic silicon compound of the present invention includes a hydrolyzable alkoxy group, and an alkenyl group or an hydrogen atom directly bonded to a silicon atom, while improving the wettability between the silicone and the heat conductive filler, due to a curing reaction of the alkenyl group or the hydrogen atom directly bonded to a silicon atom, an organic silicon compound is incorporated in a silicone crosslinking structure, without damaging the strength of a cured material of the curable thermal conductive silicone composition, the heat conductive filler may be filled at the high density. The organic silicon compound of the present invention like this may be suitably blended in the thermal conductive silicone compound installed between a heat generating component and a heat dissipation component in, for example, an electronic device and used for heat dissipation.

### DESCRIPTION OF EMBODIMENTS

As described above, a means capable of filling a heat conductive filler in the curable thermal conductive silicone compound at the high density, and capable of suppressing strength decrease even when the heat conductive filler is filled at the high density in the curable thermal conductive silicone composition was demanded.

The present inventors found, after studying hard to achieve the above object, that a curable thermal conductive silicone composition containing a silicon compound represented by a general formula (1) can fill the heat conductive filler at the high density, and can suppress the strength decrease of a cured material, and completed the present invention.

In what follows, the present invention will be detailed. However, the present invention is not limited to these.

### (Organic silicon Compound)

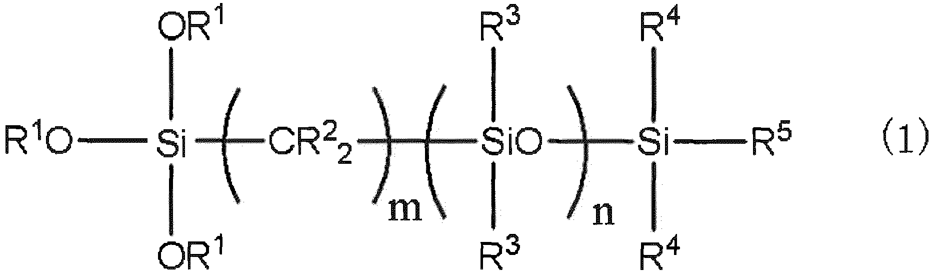

In the above formula, R¹ is an alkyl group having 1 to 6 carbon atoms, preferably 1 to 3 carbon atoms. When the number of carbon atoms of R¹ is larger than 6, the viscosity reducing effect cannot be obtained when the heat conductive filler is filled in silicone.

In the formula, R²s each is independently a hydrogen atom, a nonsubstituted monovalent hydrocarbon group, or a group obtained by substituting a part or all of hydrogen atoms bonded to carbon atoms of a monovalent hydrocarbon group with halogen atoms, the number of carbon atoms is preferably 1 to 8, more preferably 1 to 5, and still more preferably 1 to 3. Specific examples of R² include: alkyl groups such as a methyl group, an ethyl group, a propyl group, an isopropyl group, a butyl group, a t-butyl group, a pentyl group, a hexyl group, and an octyl group; and cycloalkyl groups such as a cyclopentyl group and a cyclohexyl group. Furthermore, groups obtained by substituting a part or all of hydrogen atoms bonded to carbon atoms of these hydrocarbon groups with halogen atoms such as fluorine, bromine, or chlorine may be used, for example, halogenated monovalent hydrocarbon group such as a chloromethyl group, a bromoethyl group, a 3,3,3-trifluoropropyl group, 2-(nonafluorobutyl)ethyl group, or a p-chlorophenyl group may be used. R² is preferable particularly to be a hydrogen atom from the viewpoint of easiness of synthesis of the organic silicon compound of the present invention and economic efficiency.

In the above formula, R³ and R⁴ each is independently a nonsubstituted monovalent hydrocarbon group, or a group obtained by substituting a part or all of hydrogen atoms bonded to carbon atoms of a monovalent hydrocarbon group with halogen atoms, the number of carbon atoms is preferably 1 to 8, more preferably 1 to 5, and still more preferably 1 to 3. Specific examples of the R³ and R⁴ include: alkyl groups such as a methyl group, an ethyl group, a propyl group, an isopropyl group, a butyl group, a t-butyl group, a pentyl group, a hexyl group, and an octyl group; and cycloalkyl groups such as a cyclopentyl group and a cyclohexyl group. Furthermore, groups obtained by substituting a part or all of hydrogen atoms bonded to carbon atoms of these hydrocarbon groups with halogen atoms such as fluorine, bromine, or chlorine may be used, for example, halogenated monovalent hydrocarbon group such as a chloromethyl group, a bromoethyl group, a 3,3,3-trifluoropropyl group, 2-(nonaflucrobutyl)ethyl group, or a p-chlorophenyl group may be used. R³ and R⁴ are particularly preferable to be a methyl group and an ethyl group from the viewpoint of easiness of synthesis of the organic silicon compound of the present invention and economic efficiency.

In the formula, m is 1 to 30, and preferably 1 to 15. When the m is larger than 30, a molecular weight of the organic silicon compound itself becomes larger to be high in the viscosity. In this case, when an addition amount of the organic silicon compound to the thermal conductive silicone composition becomes larger, due to the viscosity of the organic silicon compound itself, the viscosity of the thermal conductive silicone composition becomes higher to be disadvantageous for high filling of the heat conductive filler.

In the above formula, n is 3 to 4. When the n is larger than 4, a molecular weight of the organic silicon compound itself becomes larger to be result in higher viscosity. In this case, when an addition amount of the organic silicon compound to the thermal conductive silicone composition becomes larger, due to the viscosity of the organic silicon compound itself, the viscosity of the thermal conductive silicone composition becomes higher to be disadvantageous for high filling of the heat conductive filler.

As specific examples of the organic silicon compounds represented by the general formula (1), the following structures are cited without limiting to these.

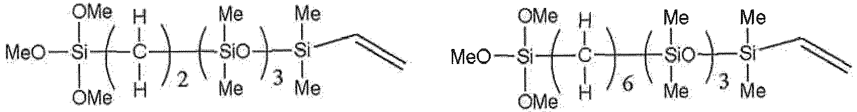

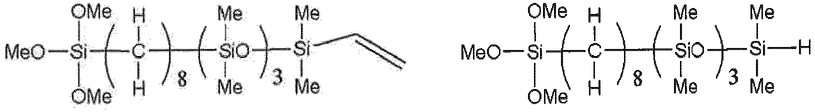

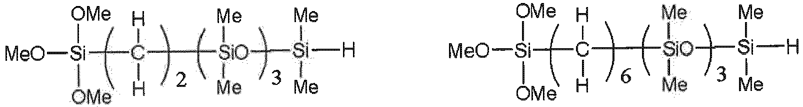

The organic silicon compounds represented by the general formula (1) may be produced as shown below. Although specific compounds are used to explain, the present invention is not limited to these.

### (I) Step

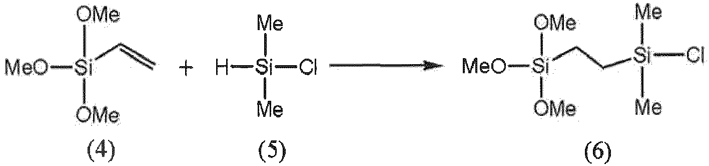

### (II) Step

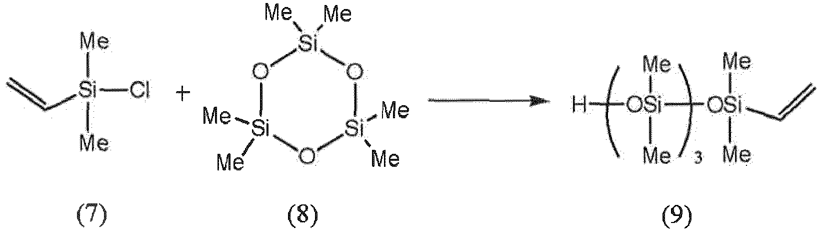

### (III) Step

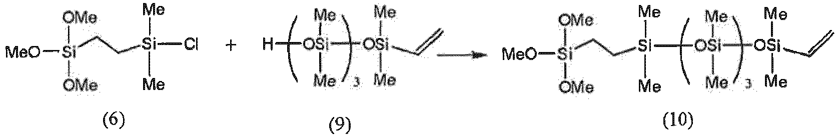

In the (I) step, when vinyl trimethoxysilane (4) and dimethylhydrochlorosilane (5) are reacted under the presence of a hydrosilylation catalyst, a one terminal trimethoxychlorosilane (6) is obtained.

The reaction may be performed under the absence of a solvent, or may be performed under the presence of the solvent such as toluene. A reaction temperature is 70 to 90°C, and a reaction time is 2 to 3 hours. An equivalent relationship is that 1.1 to 1.3 mol, preferably 1.1 to 1.2 mol of dimethylhydrochlorosilane (5) relative to 1 mol of vinyl trimethoxy silane (4).

In the (II) step, by causing a ring-opening polymerization of dimethylvinylchlorosilane (7) and dimethyl cyclic siloxane (8), one terminal hydroxy one terminal vinyl siloxane (9) is obtained.

The reaction may be performed under the absence of a solvent, or may be performed under the presence of a solvent such as acetonitrile or the like. A reaction temperature is room temperature to 60°C, and a reaction time is 2 to 15 hours. An equivalent relationship is that 1.0 to 1.2 mol, preferably 1.0 to 1.05 mol of dimethyl cyclosiloxane (8) relative to 1 mol of dimethyl vinyl chlorosilane (7).

In the (III) step, one terminal trimethoxy chlorosilane (6) and one terminal hydroxy one terminal vinyl siloxane (9) are subjected to a dehydrochlorination reaction, and a targeted silicon compound (10) is obtained.

This reaction may be performed under the absence of a solvent, or may be performed under the presence of a solvent such as toluene. A reaction temperature is 50°C to 70°C, and a reaction time is 2 to 3 hours. An equivalent relationship is that 1.0 to 1.1 mol, preferably 1.0 to 1.05 mol of one terminal hydroxy one terminal vinyl siloxane (9) relative to 1 mol of one terminal trimethoxychlorosilane (6).

### (Curable Thermal Conductive Silicone Composition)

Although the thermal conductive silicone composition of the present invention contains the organic silicon compound, a (A) component to a (F) component which will be described below are preferably contained.

### (A) Component: Organopolysiloxane

Organopolysiloxane that is the (A) component is alkenyl group-containing organopolysiloxane having two or more alkenyl groups bonded to a silicon atom in one molecule, and becomes a main agent of the curable thermal conductive silicone composition of the present invention. Although a molecular structure of the (A) component may have, without particularly limiting to these, a straight chain, a partially branched straight chain or a ring, from the viewpoint of physical properties such as the mechanical strength of the curable thermal conductive silicone composition, straight chain diorganopolysiloxane is preferable.

Examples of the functional groups other than the alkenyl group bonding to a silicon atom of the (A) component include unsubstituted or substituted monovalent hydrocarbon groups, without particularly limiting, for example, alkyl groups such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, and a dodecyl group; cycloalkyl groups such as a cyclopentyl group, a cyclohexyl group, and a cycloheptyl group; aryl groups such as a phenyl group, a tolyl group, a xylyl group, a naphthyl group, and a biphenylyl group; aralkyl groups such as a benzyl group, a phenylethyl group, a phenylpropyl group, and a methylbenzyl group; and groups obtained by substituting a part or all of hydrogen atoms bonded to a carbon atom in these groups with a halogen atom such as fluorine, chlorine and bromine, or a cyano group, for example, a chloromethyl group, a 2-bromoethyl group, a 3-chloropropyl group, a 3,3,3-trifluoropropyl group, a chlorophenyl group, a fluorophenyl group, a cyanoethyl group, a 3,3,4,4,5,5,6,6,6-nonafluorohexyl group may be cited, as typical one, ones having 1 to 10 carbon atoms, as particularly typical one, one having 1 to 6 carbon atoms, preferably, a nonsubstituted or substituted alkyl group having 1 to 3 carbon atoms such as a methyl group, an ethyl group, a propyl group, a chloromethyl group, a bromoethyl group, a 3,3,3,-trifluoropropyl group, and a cyanoethyl group, and nonsubstituted or substituted phenyl groups such as a phenyl group, a chlorophenyl group, and a fluorophenyl group. Furthermore, all functional groups other than the alkenyl group bonded to a silicon atom are not limited to be the same.

Furthermore, as the alkenyl group contained in the (A) component, usually ones having about 2 to 8 carbon atoms such as a vinyl group, an allyl group, a propenyl group, an isopropenyl group, a butenyl group, a hexenyl group, and a cyclohexenyl group are used. Preferable ones are lower alkenyl groups such as a vinyl group, an allyl group, and more preferable one is a vinyl group.

The dynamic viscosity at 25°C of the (A) component is preferably in the range of 10 to 1000000 mm²/s, and more preferably of 100 to 4000 mm²/s. The (A) component having the dynamic viscosity in the above range does not damage the fluidity of the obtained curable thermal conductive silicone composition and may become easy to fill the heat conductive filler.

Organopolysiloxane of the (A) component may be used alone or in a combination of two or more kinds having different viscosity.

### (B) Component: Organohydrogenpolysiloxane

The (B) component is organohydrogenpolysiloxane having two or more, preferably 2 to 100 hydrogen atoms (Si-H group) directly bonded to a silicon atom in average in a molecule, and works as a crosslinking agent of the (A) component. That is, a Si-H group in the (B) component and an alkenyl group in the (A) component are added by a hydrosilylation reaction promoted by a platinum-based curing catalyst of a (D) component described below to generate a three-dimensional network structure having a crosslinked structure. When the number of the Si-H groups in a molecule is two or more in average, there is no fear of not curing.

By the way, as an amount of the (B) component contained in the curable thermal conductive silicone composition, the number of moles of the Si-H groups contained in the (B) component is preferable to an amount that becomes 0.1 to 5.0 times the number of moles of the alkenyl groups derived from the (A) component.

### (C) Component: Heat Conductive Filler

The (C) component is a heat conductive filler, and as the (C) component, non-magnetic materials generally considered to be a heat conductive filler such as metals such as copper or aluminum; metal oxides such as alumina, silica, magnesia, colcothar, beryllia, titania or zirconia; metal nitrides such as aluminum nitride, silicon nitride and boron nitride; metal hydroxide such as magnesium hydroxide; and artificial diamond or silicon carbide may be used. A particle size is preferably 0.1 to 200 µm. Furthermore, one or two or more kinds of the (C) components may be used as a composite.

By the way, as an amount of the (C) component contained in the curable thermal conductive silicone composition, relative to 100 parts by mass of the (A) component, 200 to 3000 parts by mass is preferable.

### (D) Component: Platinum-based Curing Catalyst

A platinum-based curing catalyst of the (D) component is a catalyst for promoting an addition reaction of an alkenyl group derived from the (A) component, and a Si-H group derived from the (B) component, and a catalyst well-known as a catalyst used in a hydrosilylation reaction may be used. Specific examples thereof include: platinum group metal simple substance such as platinum (including platinum black), rhodium, and palladium; platinum chloride, chloroplatinic acid and chloroplatinate such as H₂PtCl₄·nH₂O, H₂PtCl₆·nH₂O, NaHPtCl₆·nH₂O, KaHPtCl₆·nH₂O, Na₂PtCl₆·H₂O, K₂PtCl₄·nH₂O, PtCl₄·nH₂O, PtCl₂, and Na₂HPtCl₄·nH₂O (here, in the formula, n is an integer of 0 to 6, preferably 0 or 6); alcohol-modified chloroplatinic acid (see specification of USP No. 3,220,972); complexes of chloroplatinic acid and olefin (USP Nos. 3,159,601 specification, No. 3,159,662 specification and No. 3,775,452 specification); ones obtained by supporting a platinum group metal such as platinum black and palladium on a support such as alumina, silica or carbon; a rhodium-olefin complex, chlorotris (triphenylphosphine)rhodium (Wilkinson catalyst); and, complexes of platinum chloride, chloroplatinic acid or chloroplatinate and a vinyl group-containing siloxane, in particular, a vinyl group-containing cyclic siloxane may be used.

By the way, an amount of the (D) component contained in the curable thermal conductive silicone composition is preferably an amount to be 0.1 to 1000 ppm in terms of mass of the platinum group element relative to the (A) component.

### (E) Component: Addition Reaction Control Agent

To the curable thermal conductive silicone composition of the present invention, an addition reaction control agent may be used as the (E) component. As the addition reaction control agent, all of well-known addition reaction control agents used in a usual addition reaction curable silicone composition may be used. For example, acetylene compounds such as 1-ethynyl-1-hexanol and 3-buthine-1-ol or various kinds of nitrogen compounds, organophosphorous compounds, oxime compounds, and organochlorine compounds may be used. By the way, the (E) component may be contained by an effective amount in the curable thermal conductive silicone composition, that is, 0.1 to 1 part by mass relative to 100 parts by mass of the (A) Component.

### (F) Component: Surface preparation agent

In the curable thermal conductive silicone composition of the present invention, with an object of uniformly dispersing the (C) component in the curable thermal conductive silicone composition by hydrophobizing the (C) component during preparation of the composition to improve the wettability with the (A) component or the (B) component, the (F) component may be blended. As the (F) component, the organic silicon compound of the present invention may be used as a (F-1) component.

The (F-1) component causes an addition reaction with the alkenyl group of the (A) component when the R⁵ in the formula is a hydrogen atom. At this time, an amount of the (B) component is preferable to be an amount such that the number of moles of the Si-H groups contained in the (F-1) component and (B) component is 0.01 to 0.5 time the number of moles of the alkenyl groups derived from the (A) component. Furthermore, when the R⁵ is an alkenyl group, it causes an addition reaction with a Si-H group of the (B) component. At this time, an amount of the (B) component is preferable to be an amount such that the number of moles of Si-H groups contained in the (B) component is 0.1 to 2 times the number of moles of the alkenyl groups derived from the (A) component and (F-1) component.

By the way, as an amount of the (F-1) component contained in the curable thermal conductive silicone composition is preferably 0.01 to 200 parts by mass relative to an amount of the (A) component of 100 parts by mass.

Furthermore, the (F) component of the curable thermal conductive silicone composition of the present invention preferably contains, relative to 100 parts by mass of the amount of the (A) component, 0.01 to 110 parts by mass of at least one kind selected from the group consisting of an alkoxysilane compound represented by the following general formula (2) as the (F-2) component

**R⁶ₐR⁷_{b}Si(OR⁸)_{4-a-b}** **(2)**

(In the formula, R⁶ represents independently an alkyl group having 6 to 15 carbon atoms, R⁷ represents independently a nonsubstituted or substituted monovalent hydrocarbon group having 1 to 12 carbon atoms, R⁸ represents independently an alkyl group having 1 to 6 carbon atoms, "a" represents an integer of 1 to 3, "b" represents an integer of 0 to 2, however a + b is an integer of 1 to 3.) and, as a (F-3) component, dimethylpolysiloxane represented by the following general formula (3) in which one terminal of the molecular chain is sealed with a tri-alkoxy group 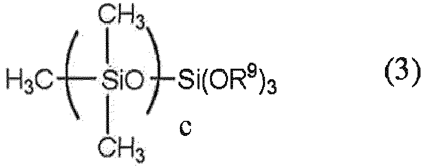 (In the formula, R⁹ represents independently an alkyl group having 1 to 6 carbon atoms, and c is an integer of 5 to 100.) In what follows, the (F-2) and (F-3) components will be more detailed.

### (F-2) Component: Alkoxysilane Compound

The (F-2) component is an alkoxysilane compound represented by the following general formula (2).

**R⁶ₐR⁷_{b}Si(OR⁸) _{4-a-b}** **(2)**

In the formula, R⁶ independently represents an alkyl group having 6 to 15 carbon atoms, and examples thereof include a hexyl group, an octyl group, a nonyl group, a decyl group, a dodecyl group, and a tetradecyl group. When the number of carbon atoms of the alkyl group represented by R⁶ satisfies the range of 6 to 15, the wettability of the (C) component is sufficiently improved, handling properties become excellent, and the low temperature characteristics of the composition become excellent.

In the formula, R⁷ independently represents a nonsubstituted or substituted monovalent hydrocarbon group having 1 to 12 carbon atoms, preferably 1 to 10, more preferably 1 to 6 carbon atoms. Examples thereof include: alkyl groups such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, and a dodecyl group; cycloalkyl groups such as a cyclopentyl group, a cyclohexyl group, and a cycloheptyl group; aryl groups such as a phenyl group, a tolyl group, a xylyl group, a naphthyl group, and a biphenylyl group; aralkyl groups such as a benzyl group, a phenylethyl group, a phenylpropyl group, and a methylbenzyl group; and groups obtained by substituting a part or all of hydrogen atoms bonded to a carbon atom in these groups with a halogen atom such as fluorine, chlorine and bromine, or a cyano group, for example, a chloromethyl group, a 2-bromoethyl group, a 3-chloropropyl group, a 3,3,3-trifluoropropyl group, a chlorophenyl group, a fluorophenyl group, a cyanoethyl group, a 3,3,4,4,5,5,6,6,6-nonafluorohexyl group may be cited, preferably, nonsubstituted or substituted alkyl groups having 1 to 3 carbon atoms such as a methyl group, an ethyl group, a propyl group, a chloromethyl group, a bromoethyl group, a 3,3,3-trifluoropropyl group, and a cyanoethyl group, a nonsubstituted or substituted phenyl group such as a phenyl group, a chlorophenyl group, and a fluorophenyl group.

In the above formula, R⁸ independently represents an alkyl group having 1 to 6 carbon atoms, "a" is an integer of 1 to 3, "b" is an integer of 0 to 2, however, a + b is an integer of 1 to 3.

### (F-3) Component: Dimethylpolysiloxane

The (F-3) component is dimethylpolysiloxane represented by the following general formula (3) in which one terminal of the molecular chain is sealed with a trialkoxy group.

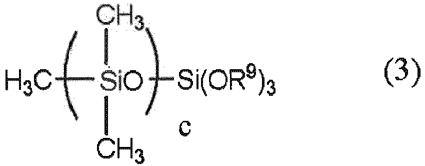

In the above formula, R⁹ is the same kind as the alkyl group represented by the R⁸ in the above general formula (2) and is independently an alkyl group having 1 to 6 carbon atoms. Furthermore, c is an integer of 5 to 100.

As the surface preparation agent (F), any one of the (F-2) component and the (F-3) component, or a combination of both may be used.

### (Curing Method of Curable Thermal Conductive Silicone Composition)

As a curing method of the curable thermal conductive silicone composition, an addition reaction using a platinum-based curing catalyst or a radical reaction using a peroxide as an initiator may be used, without limiting to anyone.

When the platinum-based curing catalyst acts on the alkenyl group and the Si-H group, the addition reaction proceeds to form a silethylene structure. The reaction mechanism is as follows. When the platinum-based curing catalyst is oxidatively added between the Si-H bonds, a Si-Pt-H reaction species is generated. Furthermore, when the alkenyl group is coordinated to a platinum atom, a hydride on the platinum atom approaches the alkenyl group, the hydride nucleophilically attacks the alkenyl group, the platinum-based curing catalyst is reductively eliminated to form a silethylene structure to regenerate the platinum-based curing catalyst.

Since the organic silicon compound of the present invention like this has a hydrolyzable alkoxy group and an alkenyl group or a hydrogen atom directly bonded with a silicon atom in a molecule, while improving the wettability of the silicone and the heat conductive filler, due to a curing reaction of an alkenyl group or a hydrogen atom directly bonded with a silicon atom, the organic silicon compound is incorporated in a silicone crosslinking structure, therefore, without damaging the strength of a cured material of the curable thermal conductive silicone composition, the heat conductive filler may be filled at the high density.

### EXAMPLE

In what follows, the present invention will more specifically described with reference to Examples and Comparative Examples. However, the present invention is not limited to the following examples.

### (Preparation Example 1)

### (I) Step

In a 1 L round separable flask, via a four-necked separable cover, a stirrer, a coiled cooling pipe, and a dropping funnel were provided. In this separable flask, 175.2 g (1.18 mol) of vinyltrimethoxysilane (4) and 0.4 g of a chloroplatinic acid 2 mass% 2-ethylcyclohexanol solution were added followed by heating such that the a reaction system becomes 75 to 85°C, further followed by dropping 123.3 g (1.30 mol) of dimethylhydrochlorosilane (5) over 2 hours. The proceeding of the reaction was traced by gas chromatography, the reaction was continued until a peak of the vinyltrimethoxysilane (4) disappeared, and 272 g of one terminal trimethoxychlorosilane (6) that is a target object was obtained at a yield of 109%.

### (II) Step

In a 1 L round separable flask, via a four-necked separable cover, a stirrer and a coiled cooling pipe were provided. In this separable flask, 400 g of toluene, 125.5 g (1.0 mol) of dimethylvinylchlorosilane (7), 222.5 g (1.0 mol) of dimethyl cyclic siloxane (8), 6.0 g (1.18 mol) of HMPA (hexamethylphosphoramide) were charged, followed by stirring at room temperature for 12 hours. Thereafter, 256 g of triethylamine was added to neutralize.

In a 3L separable flask with a jacket, via a four-necked separable cover, a stirrer was provided. In this separable flask, 2400 g of water, and an appropriate amount of ice were added, the neutralized content in the 1L separable flask was added thereto, followed by stirring for 1 hour. After an aqueous phase was separated, followed by washing with water. The oil layer was isolated and transferred into the 1L separable flask, followed by distilling a solvent and a starting material at 100°C under 12 mmHg (wherein 1 mmHg = 133.322 Pa) reduced pressure, thus, 140 g of one terminal hydroxy one terminal vinyl siloxane (9) that is a target object was obtained.

### (III) Step

In a 500 mL separable flask, via a four-necked separable cover, a stirrer, a coiled cooling pipe, and a dropping funnel were provided. 100 g of toluene, 30.3 g of triethylamine, and 72.9 g (0.3 mol) of one terminal trimethoxychlorosilane (6) were added and heated at 30 to 40°C. There, with a dropping funnel, 97.2 g (0.3 mol) of one terminal hydroxy one terminal vinyl siloxane (9) were dropped over 1 hour, followed by stirring at 50 to 60°C for 2 hours. Thereafter, 0.5 g of methanol was added, returning to room temperature, followed by stirring for 12 hours, the reaction system was filtered with a filter paper, followed by charging in a 500 mL separable flask, under 20 mmHg (wherein 1 mmHg = 133.322 Pa) reduced pressure, the solvent or the starting material were distilled at 120°C over two hours, and 70 g of a silicon compound (10) that is a target object was obtained.

### (Preparation example 2)

### (I) Step

In a 1 L round separable flask, via a four-necked separable cover, a stirrer, a coiled cooling pipe, and a dropping funnel were provided. In this separable flask, 200 g of toluene, 300 g (1.29 mol) of trimethoxyvinylsilane (11) and 0.4 g of 2-ethylcyclohexanol solution of 2 mass% of chloroplatinic acid were added followed by heating such that the reaction system is 75 to 85°C, further followed by dropping 134 g (1.40 mol) of dimethylhydrochlorosilane (5) over 2 hours. The proceeding of the reaction was traced by gas chromatography, and the reaction was continued until a peak of the trimethoxyvinylsilane (11) disappeared. Under reduced pressure of 7 mmHg (wherein 1 mmHg = 133.322 Pa), for two hours at 150 to 170°C, the solvent and the starting material were distilled, thus 205 g of one terminal trimethoxychlorosilane (12) that is a target object was obtained.

### (II) Step

In the same manner as the (II) step of the preparation example 1, one terminal hydroxy one terminal vinyl siloxane (9) that is a target object was obtained.

### (III) Step

In a 500 mL separable flask, via a four-necked separable cover, a stirrer, a coiled cooling pipe, and a dropping funnel were provided. 100 g of toluene, 30.3 g of triethylamine, and 97.9 g (0.3 mol) of one terminal trimethoxychlorosilane (12) were added and heated at 30 to 40°C. There, with a dropping funnel, 97.2 g (0.3 mol) of one terminal hydroxy one terminal vinyl siloxane (9) was dropped over 1 hour, followed by stirring at 50 to 60°C for 2 hours. Thereafter, 0.5 g of methanol was added, returning to room temperature, followed by stirring for 12 hours, the reaction system was filtered with a filter paper, followed by charging in a 500 mL separable flask, under 10 mmHg (wherein 1 mmHg = 133.322 Pa) reduced pressure, the solvent or the starting material were distilled at 120°C over two hours, and 103 g of a silicon compound (13) that is a target object was obtained.

### (Preparation example 3)

### (I) Step

In the same manner as the (I) step of the preparation example 2, one terminal trimethoxychlorosilane (12) that is a target object was obtained.

### (II) Step

In a 1 L round separable flask, via a four-necked separable cover, a stirrer and a coiled cooling pipe were provided. In this separable flask, 400 g of toluene, 191.1 g (2.0 mol) of dimethylhydrochlorosilane (5), 445 g (2.0 mol) of dimethyl cyclic siloxane (8), and 12.0 g (2.36 mol) of HMPA (hexamethylphosphoramide) were charged, followed by stirring at room temperature for 12 hours. Thereafter, 205 g of triethylamine was added to neutralize.

In a 3 L separable flask with a jacket, via a four-necked separable cover, a stirrer was provided. In this separable flask, 2400 g of water and an appropriate amount of ice were added, the neutralized content in the 1L separable flask was added thereto, followed by stirring for 1 hour. After separating an aqueous phase, followed by washing with water. The oil phase was isolated, transferred into 1L separable flask, followed by distilling the solvent and the starting material under reduced pressure of 12 mmHg (wherein 1 mmHg = 133.322Pa) and 100°C, thus, 360 g of one terminal hydroxy one terminal hydrosiloxane (14) that is a target subject was obtained.

### (III) Step

In a 500 mL separable flask, via a four-necked separable cover, a stirrer, a coiled cooling pipe, and a dropping funnel were provided. 100 g of toluene, 30.3 g of triethylamine, and 97.9 g (0.3 mol) of one terminal trimethoxychlorosilane (12) were added and heated at 30 to 40°C. There, with a dropping funnel, 89.6 g (0.3 mol) of one terminal hydroxy one terminal hydrosiloxane (14) was dropped over 1 hour, followed by stirring at 50 to 60°C for 2 hours. Thereafter, 0.5 g of methanol was added, returning to room temperature, after stirring for 12 hours, the reaction system was filtered with a filter paper, followed by charging in a 500 mL separable flask, under 20 mmHg (wherein 1 mmHg = 133.322Pa) reduced pressure, the solvent or the starting material were distilled at 170°C over two hours, and 94 g of a silicon compound (15) that is a target object was obtained.

Structures of the trimethoxyvinylsilane (11), one terminal trimethoxychlorosilane (12), and one terminal hydroxy one terminal hydrosiloxane (14) are shown below.

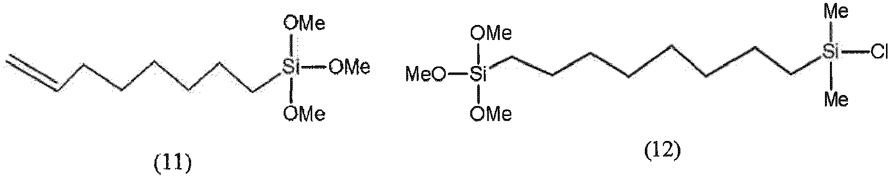

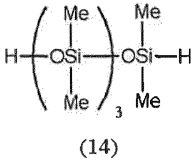

Structures of (10), (13) and (15) corresponding to the silicon compounds of the present invention are as shown below, and are identified with ²⁹Si-NMR, and ¹H-NMR. 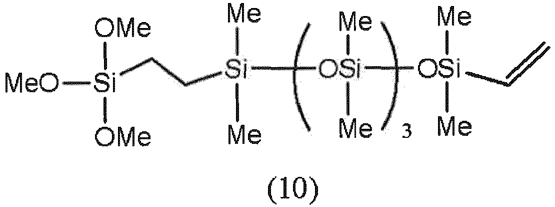 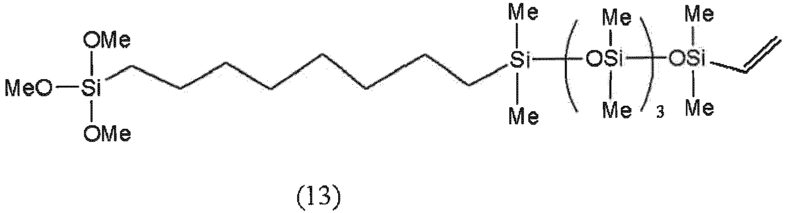 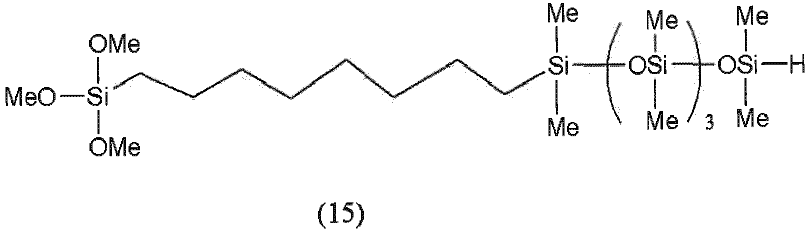
(10)
   ²⁹Si-NMR (C6D6)
   δ10.13 to 8.60 ppm (O-Si-CH₂)
   -3.15 to -3.77 ppm (-Si-CHCH₂)
   -20.30 to -21.52 ppm (-Si(CH₃)₂-)
   -43.79 to 44.30 ppm (-Si(OCH₃)₃)
   ¹H-NMR (CDCl₃)
   δ6.10 to 5.63 ppm (m, 3H, -Si-CHCH₂)
   3.94 to 3.36 ppm (m, 9H, -Si(OCH₃)₃)
   1.43 to 0.94 ppm (m,4H, -(CH₂)₂-)
   0.73 to -0.17 ppm (m,24H, -Si(CH₃)₂-)
(13)
   ²⁹Si-NMR (C6D6)
   δ8.22 to 7.90 ppm (O-Si-CH₂)
   -3.38 to -3.44 ppm (-Si-CHCH₂)
   -20.35 to -21.58 ppm (-Si(CH₃)₂-)
   -40.82 to 40.99 ppm (-Si(OCH₃)₃)
   ¹H-NMR (CDCl₃)
   δ6.11 to 5.69 ppm (m, 3H, -Si-CHCH₂)
   3.55 to 3.3.28 ppm (m, 9H, -Si(OCH₃)₃)
   1.33 to 1.22 ppm (m, 16H, -(CH₂)₈-)
   0.60 to -0.16 ppm (m,24H, -Si(CH₃)₂-)
(15)
   ²⁹Si-NMR (C6D6)
   δ10.48 to 7.95 ppm (O-Si-CH₂)
   -10.59 to -11.32 ppm (-Si-H)
   -20.94 to -21.05 ppm (-Si(CH₃)₂-)
   -40.97 to 44.59 ppm (-Si(OCH₃)₃)
   ¹H-NMR (CDCl₃)
   δ4.70 to 4.64 ppm (m, 1H, -Si-H)
   3.54 to 3.3.35 ppm (m, 9H, -Si(OCH₃)₃)
   1.33 to 1.22 ppm (m, 16H, -(CH₂)₈-)
   0.60 to -0.11 ppm (m,24H, -Si(CH₃)₂-)

### (Examples 1 to 3, Comparative Examples 1 to 3)

### (Preparation of Composition)

(A) to (F) components used in examples 1 to 3 and comparative examples 1 to 3 are shown below. By the way, in Comparative Example 3, an organic silicon compound (G) that does not satisfy a condition of the (F) component of the present invention was used.

### (A) Component:

Organopolysiloxane that is represented by the following general formula (17), has a vinyl group as X, an average polymerization degree of 1000, and the viscosity of 30000 mm²/s.

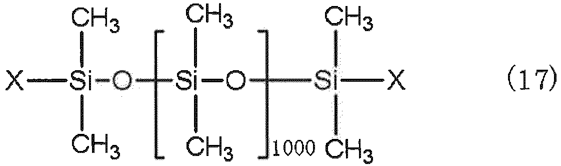

### (B) Component:

Hydrogen polysiloxane represented by the following general formula (18), having o=27 and p=3.

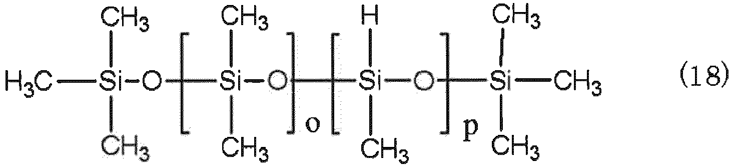

### (C) Component:

(C-1) Spherical alumina having average particle size of 1 µm
(C-2) Spherical alumina having average particle size of 10 µm

### (D) Component: An 2-ethyl hexanol solution of 5% chloroplatinic acid

### (E) Component: Ethynyl methylidene carbinol

### (F) Component

(F-1-1) component: The silicon compound (10) of the present invention prepared in preparation example 1
(F-1-2) component: The silicon compound (13) of the present invention prepared in preparation example 2
(F-2) component: Trimethoxysilane represented by the following general formula (2), where R⁶= octyl group, R⁷=methyl group, R⁸= methyl group, a=2, and b=1.

   **R⁶ₐR⁷_{b} Si(OR⁸)_{4-a-b}** **(2)**
(F-3) component: Dimethylpolysiloxane represented by the following general formula (19) in which one terminal is sealed with a trimethoxysilyl group and the average polymerization degree is 30

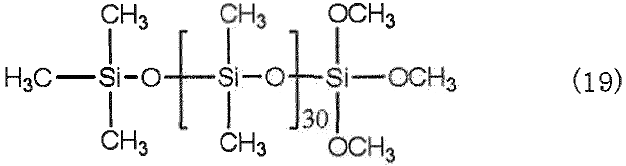

### (G) Component:

Organic silicon compound represented by the following general formula (20), where R¹, R², R³, R⁴ = a methyl group, R⁵ =a vinyl group, m=3, and n=6

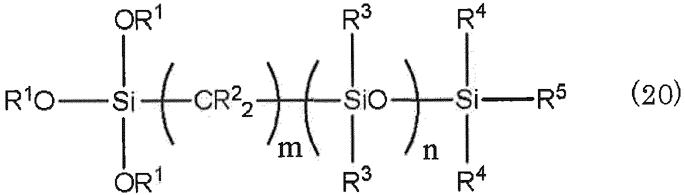

(A) to (G) components in amounts described in Table 1 and Table 2 were kneaded with a planetary mixer for 60 minutes and a curable thermal conductive silicone composition was obtained.

### (Molding method)

The obtained composition was flowed into a metal mold and molded with a press molding machine at 120°C for 10 minutes.

### (Evaluation Method)

Viscosity: The viscosity of the obtained composition was measured by a Malcom viscometer at the rotation number of 10 rpm.

Hardness: The obtained composition was cured into a sheet having a thickness of 6 mm, and the two sheets were overlapped and measured by a Durometer A Hardness Meter.

Tensile strength, elongation, and tearing strength: measured according to JIS K 6249.

**(Table 1)**

| Component | | Example | | |
|---|---|---|---|---|
| | | 1 | 2 | 3 |
| A | | 100 | 100 | 100 |
| B | | 60 | 61 | 61 |
| C | C-1 | 1900 | 1900 | 1900 |
| | C-2 | 800 | 800 | 800 |
| D | | 1.0 | 1.0 | 1.0 |
| E | | 0.5 | 0.5 | 0.5 |
| F-1-1 | | 30 | | 10 |
| F-1-2 | | | 30 | |
| F-2 | | | | 10 |
| F-3 | | 80 | 80 | 90 |
| G | | | | |
| Viscosity (Pa-s) | | 380 | 420 | 360 |
| Hardness (Durometer A) | | 87 | 95 | 85 |
| Tensile strength (MPa) | | 2.1 | 3.4 | 1.6 |
| Elongation (%) | | 28 | 27 | 25 |
| Tearing strength (kN/m) | | 6.1 | 8.9 | 5.3 |

**(Table 2)**

| Component | | Comparative Example | | |
|---|---|---|---|---|
| | | 1 | 2 | 3 |
| A | | 100 | 100 | 100 |
| B | | 4 | 18 | 60 |
| C | C-1 | 1900 | 1900 | 1900 |
| | C-2 | 800 | 800 | 800 |
| D | | 1.0 | 1.0 | 1.0 |
| E | | 0.5 | 0.5 | 0.5 |
| F-1-1 | | | | |
| F-1-2 | | | | |
| F-2 | | 110 | 80 | |
| F-3 | | | 30 | 80 |
| G | | | | 30 |
| Viscosity (Pa-s) | | 420 | 390 | 470 |
| Hardness (Durometer A) | | 30 | 28 | 86 |
| Tensile strength (MPa) | | 0.5 | 0.8 | 2.5 |
| Elongation (%) | | 10 | 13 | 28 |
| Tearing strength (kN/m) | | 1.7 | 1.4 | 6.6 |

From results of Table 1, in Examples 1 to 3 where the organic silicon compounds of the present invention were used, curable thermal conductive silicone compositions excellent in hardness, tensile strength, elongation, and tearing strength were obtained. On the other hand, from results of Table 2, in the cases where the organic silicon compound of the present invention was not used like in Comparative Examples 1, 2, the hardness, tensile strength, elongation, and tearing strength of the curable thermal conductive silicone composition became remarkably low. Furthermore, when the number of n of the formula (1) is larger than 4 like in Comparative Example 3, the viscosity of the thermal conductive silicone compound increased. When the viscosity of the organic silicon compound itself becomes higher and the viscosity of the thermal conductive silicone composition increase, the moldability and processability are disadvantageous.

From what was described above, it was obvious that the organic silicon compound of the present invention can fill the heat conductive filler at high density, furthermore, even when the heat conductive filler is filled at high density, the organic silicon compound can be suitably used in the curable thermal conductive silicone composition capable of suppressing the strength deterioration.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A curable thermal conductive silicone composition **characterized by** including:
(A) organopolysiloxane having at least two alkenyl groups bonded to a silicon atom in a molecule; 100 parts by mass,
(B) organohydrogenpolysiloxane having at least two hydrogen atoms directly bonded to a silicon atom in a molecule; the number of moles of hydrogen atoms directly bonded to a silicon atom is an amount to be 0.1 to 5.0 times the number of moles of alkenyl groups derived from the (A) component,
(C) a heat conductive filler; 200 to 3000 parts by mass,
(D) a platinum-based curing catalyst; an amount to be 0.1 to 1000 ppm in terms of the platinum group element mass relative to the (A) component,
(E) an addition reaction control agent; an effective amount, and
(F-1) an organic silicon compound represented by the following general formula (1); 0.01 to 200 parts by mass: 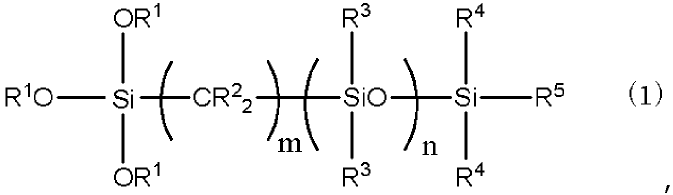 wherein in the formula (1), R¹ represents an alkyl group having 1 to 6 carbon atoms, R² represents independently a hydrogen atom, a nonsubstituted monovalent hydrocarbon group, or a group obtained by substituting a part or all of hydrogen atoms bonded to carbon atoms of a monovalent hydrocarbon group with halogen atoms, R³ and R⁴ each represents independently a nonsubstituted monovalent hydrocarbon group, or a group obtained by substituting a part or all of hydrogen atoms bonded to carbon atoms of a monovalent hydrocarbon group with halogen atoms, and R⁵ represents a hydrogen atom or an alkenyl group, and m represents an integer of 1 to 30, and n represents an integer of 3 to 4.

2. The curable thermal conductive silicone composition according to claim 1, **characterized by** containing 0.01 to 110 parts by mass of at least one kind selected from the group consisting of, as a (F-2) component, an alkoxysilane compound represented by the following general formula (2):
**R⁶ₐR⁷_{b}Si(OR⁸)_{4-a-b}** **(2),**
wherein
in the formula (2), R⁶ represents independently an alkyl group having 6 to 15 carbon atoms, R⁷ represents independently a nonsubstituted monovalent hydrocarbon group having 1 to 12 carbon atoms, or a group obtained by substituting a part or all of hydrogen atoms bonded to a carbon atom in a monovalent hydrocarbon group having 1 to 12 carbon atoms with a halogen atom or a cyano group, R⁸ represents independently an alkyl group having 1 to 6 carbon atoms, and "a" represents an integer of 1 to 3, and "b" represents an integer of 0 to 2, however, a + b is an integer of 1 to 3,
and, as a (F-3) component, dimethylpolysiloxane represented by the following general formula (3) in which one terminal of the molecular chain is sealed with a tri-alkoxy group: 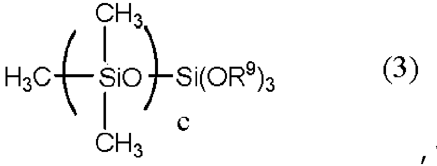 wherein in the formula (3), R⁹ represents independently an alkyl group having 1 to 6 carbon atoms and c is an integer of 5 to 100.

## Patentansprüche

1. Härtbare, wärmeleitende Silikonzusammensetzung **dadurch gekennzeichnet, dass** sie enthält:
(A) Organopolysiloxan mit mindestens zwei an ein Siliziumatom gebundenen Alkenylgruppen in einem Molekül; 100 Masseteile,
(B) Organohydrogenpolysiloxan mit mindestens zwei direkt an ein Siliziumatom gebundenen Wasserstoffatomen in einem Molekül; die Anzahl der Mole der direkt an ein Siliziumatom gebundenen Wasserstoffatome beträgt das 0,1- bis 5,0-fache der Anzahl der Mole der von der Komponente (A) abgeleiteten Alkenylgruppen,
(C) ein wärmeleitender Füllstoff; 200 bis 3000 Masseteile,
(D) einen Aushärtungskatalysator auf Platinbasis in einer Menge von 0,1 bis 1000 ppm, ausgedrückt als Masse des Platingruppenelements, bezogen auf die Komponente (A),
(E) ein Mittel zur Steuerung der Additionsreaktion; eine wirksame Menge, und
(F-1) eine organische Siliziumverbindung, dargestellt durch die folgende allgemeine Formel (1); 0,01 bis 200 Masseteile: 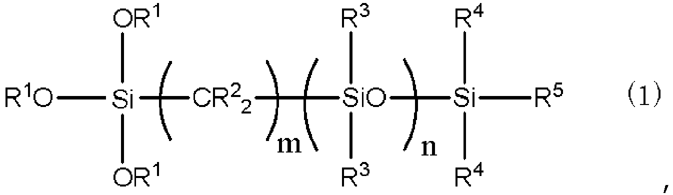 wobei in der Formel (1) stellt R¹ eine Alkylgruppe mit 1 bis 6 Kohlenstoffatomen dar, R² stellt unabhängig ein Wasserstoffatom, eine unsubstituierte einwertige Kohlenwasserstoffgruppe oder eine Gruppe dar, die durch Substitution eines Teils oder der Gesamtheit der an die Kohlenstoffatome einer einwertigen Kohlenwasserstoffgruppe gebundenen Wasserstoffatome durch Halogenatome erhalten wird, R³ und R⁴ jeweils unabhängig voneinander eine unsubstituierte einwertige Kohlenwasserstoffgruppe oder eine Gruppe, die durch Substitution eines Teils oder aller an Kohlenstoffatome einer einwertigen Kohlenwasserstoffgruppe gebundenen Wasserstoffatome durch Halogenatome erhalten wird, bedeuten und R⁵ ein Wasserstoffatom oder eine Alkenylgruppe bedeutet und m eine ganze Zahl von 1 bis 30 bedeutet und n eine ganze Zahl von 3 bis 4 bedeutet.

2. Härtbare, wärmeleitende Silikonzusammensetzung nach Anspruch 1, **dadurch gekennzeichnet, dass** sie 0,01 bis 110 Masseteile mindestens einer Art enthält, die aus der Gruppe ausgewählt ist, die aus einer (F-2)-Komponente, einer Alkoxysilanverbindung der folgenden allgemeinen Formel (2), besteht
**R⁶ₐR⁷_{b}Si(OR⁸)_{4-a-b}** **(2)**,
wobei
in der Formel (2) bedeutet R⁶ unabhängig eine Alkylgruppe mit 6 bis 15 Kohlenstoffatomen, R⁷ bedeutet unabhängig eine unsubstituierte einwertige Kohlenwasserstoffgruppe mit 1 bis 12 Kohlenstoffatomen, oder eine Gruppe, die durch Substitution eines Teils oder aller Wasserstoffatome, die an ein Kohlenstoffatom in einer einwertigen Kohlenwasserstoffgruppe mit 1 bis 12 Kohlenstoffatomen gebunden sind, durch ein Halogenatom oder eine Cyanogruppe erhalten wird, R⁸ stellt unabhängig eine Alkylgruppe mit 1 bis 6 Kohlenstoffatomen dar, und "a" stellt eine ganze Zahl von 1 bis 3 dar, und "b" stellt eine ganze Zahl von 0 bis 2 dar, jedoch ist a + b eine ganze Zahl von 1 bis 3,
und, als (F-3)-Komponente, Dimethylpolysiloxan der folgenden allgemeinen Formel (3), in der ein Ende der Molekülkette mit einer Trialkoxygruppe verschlossen ist: 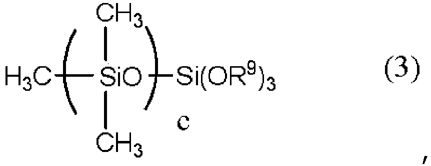 wobei in der Formel (3) stellt R⁹ unabhängig eine Alkylgruppe mit 1 bis 6 Kohlenstoffatomen dar und c ist eine ganze Zahl von 5 bis 100.

## Revendications

1. Composition de silicone thermoconductrice durcissable **caractérisée en ce qu'**elle comprend :
(A) un organopolysiloxane ayant au moins deux groupes alcényles liés à un atome de silicium dans une molécule ; 100 parties en masse,
(B) un organohydrogénopolysiloxane ayant au moins deux atomes d'hydrogène directement liés à un atome de silicium dans une molécule ; le nombre de moles d'atomes d'hydrogène directement liés à un atome de silicium est une quantité devant être de 0,1 à 5,0 fois le nombre de moles de groupes alcényles dérivés du constituant (A),
(C) une charge thermoconductrice ; 200 à 3 000 parties en masse,
(D) un catalyseur de durcissement à base de platine ; une quantité devant être de 0,1 à 1 000 ppm en termes de masse d'élément du groupe du platine par rapport au constituant (A),
(E) un agent de contrôle de réaction d'addition ; une quantité efficace, et
(F-1) un composé de silicium organique représenté par la formule générale (1) suivante ; 0,01 à 200 parties en masse : 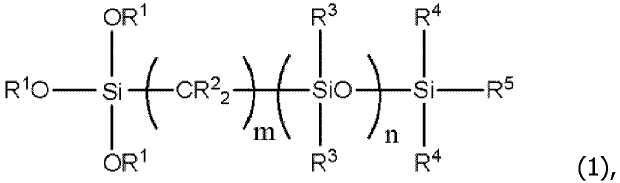
dans laquelle dans la formule (1), R¹ représente un groupe alkyle ayant 1 à 6 atomes de carbone, R² représente indépendamment un atome d'hydrogène, un groupe hydrocarboné monovalent non substitué ou un groupe obtenu par substitution d'une partie ou de la totalité des atomes d'hydrogène liés aux atomes de carbone d'un groupe hydrocarboné monovalent par des atomes d'halogène, R³ et R⁴ représentent chacun indépendamment un groupe hydrocarboné monovalent non substitué ou un groupe obtenu par substitution d'une partie ou de la totalité des atomes d'hydrogène liés aux atomes de carbone d'un groupe hydrocarboné monovalent par des atomes d'halogène, et R⁵ représente un atome d'hydrogène ou un groupe alcényle, et m représente un nombre entier de 1 à 30, et n représente un nombre entier de 3 à 4.

2. Composition de silicone thermoconductrice durcissable selon la revendication 1, **caractérisée en ce qu'**elle contient 0,01 à 110 parties en masse d'au moins un type choisi dans le groupe constitué, en tant que constituant (F-2), d'un composé alcoxy-silane représenté par la formule générale (2) suivante :
**R⁶ₐR⁷_{b}Si(OR⁸)_{4-a-b}** (2),
dans laquelle dans la formule (2), R⁶ représente indépendamment un groupe alkyle ayant de 6 à 15 atomes de carbone, R⁷ représente indépendamment un groupe hydrocarboné monovalent non substitué ayant de 1 à 12 atomes de carbone, ou un groupe obtenu par substitution d'une partie ou de la totalité des atomes d'hydrogène liés à un atome de carbone dans un groupe hydrocarboné monovalent ayant de 1 à 12 atomes de carbone par un atome d'halogène ou un groupe cyano, R⁸ représente indépendamment un groupe alkyle ayant de 1 à 6 atomes de carbone, et « a » représente un nombre entier de 1 à 3, et « b » représente un nombre entier de 0 à 2, cependant, a + b est un nombre entier de 1 à 3,
et, en tant que constituant (F-3), le diméthylpolysiloxane représenté par la formule générale (3) suivante dans laquelle une extrémité de la chaîne moléculaire est scellée par un groupe trialcoxy : 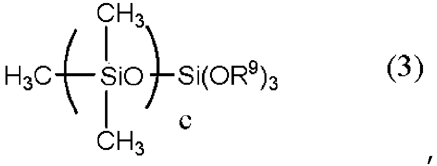
dans laquelle dans la formule (3), R⁹ représente indépendamment un groupe alkyle ayant de 1 à 6 atomes de carbone et c est un nombre entier de 5 à 100.
